# EUROPEAN PATENT SPECIFICATION

(11) **EP 3 924 689 B1**
(45) Date of publication and mention of the grant of the patent: **07.06.2023**
(21) Application number: 20704035.3
(22) Date of filing: 14.02.2020
(51) Int. Cl.: G01B 11/06, G01N 21/64, G01N 21/84, H05K 3/28

(54) **METHOD FOR OBTAINING INFORMATION ABOUT A LAYER OF AN ORGANIC SOLDERABILITY PRESERVATIVE ON A PRINTED CIRCUIT BOARD**
VERFAHREN ZUM ERHALT VON INFORMATIONEN ÜBER EINE SCHICHT EINES ORGANISCHEN LÖTBARKEITSKONSERVIERUNGSSTOFFES AUF EINER LEITERPLATTE
PROCÉDÉ D'OBTENTION D'INFORMATIONS CONCERNANT UNE COUCHE D'UN AGENT DE CONSERVATION DE SOUDABILITÉ ORGANIQUE SUR UNE CARTE DE CIRCUIT IMPRIMÉ

(30) Priority: 15.02.2019 EP 19157592
(43) Date of publication of application: 22.12.2021
(73) Proprietor: Atotech Deutschland GmbH & Co. KG, 10553 Berlin (DE)
(72) Inventor: MERTENS, Hubertus, 10553 Berlin (DE); SCHACHTNER, Bernhard, 10553 Berlin (DE)
(74) Representative: Atotech Deutschland GmbH & Co. KG
(86) International application number: PCT/EP2020/053836
(87) International publication number: WO 2020/165386

(56) References cited:
- US-A1- 2006 023 936
- US-A1- 2012 092 488
- US-B1- 6 410 926
- -: "SITA FluoScan 3D > Fluorescence Measuring and Testing Devices > Products > SITA Process Solutions", , 7 February 2017 (2017-02-07), XP055610428, Retrieved from the Internet: URL:https://web.archive.org/web/2017020710 2114/http://www.sita-process.com/products/ fluorescence-measuring-and-testing-devices /sita-fluoscan-3d/ [retrieved on 2019-08-01]

## Description

### FIELD OF THE INVENTION

The present invention relates to a method for obtaining information about a layer of an organic solderability preservative on a printed circuit board, in particular to a method for determining an individual thickness of a layer of an organic solderability preservative (OSP) on a printed circuit board

### BACKGROUND OF THE INVENTION

Printed circuit boards (PCB) comprise copper structures, such as copper conductive paths, which are placed on a non-conductive substrate. A solder resist is placed on the printed circuit board and covers the substrate and most parts of the copper structures. The solder resist comprises openings were the copper is not covered by the solder resist. These openings allow access to contact pads. Contact pads are junctions for creating a contact from the copper structure of the PCB to electronic components which are placed on the PCB and connected to the PCB by a solder connection. Contact pads may have a smaller or a larger area than an allocated opening. In order to create a solder connection, openings are filled with a soldering paste, the component is inserted and connected by reflow soldering.

Before electronic components are connected to the PCB, the PCB may be stored for weeks or months. During this time exposed copper within the contact pads, which is not covered by solder resist, would oxidize which would make a reliable solder connection impossible. This is why the contact pads are temporarily protected by a so-called organic solderability preservative (OSP). The PCB is immersed in an OSP solution and the OSP is specifically deposited on the exposed copper in the contact pads only, by reacting with the copper. So, the OSP specifically fills the openings and covers the copper surface of the contact pads in the openings. In a later soldering process the OSP is vaporized, decomposed or mixed with other components without affecting the solder resist on the PCB.

It is necessary to know whether copper of contact pads is sufficiently covered with the OSP in order to guarantee the later function of the PCB. It is particularly desired to know about the thickness of a layer of OSP on the contact pads. Although it is desired to have an identical thickness of the OSP on all contact pads, typically openings with varying dimensions result in OSPs with varying thicknesses. For these reasons, a quick and reliable method for determining the individual thickness of the OSP is highly desired.

In processes according to the state-of-the-art the thickness of an OSP is determined by cutting or grinding through the contact pad and measuring the OSP thickness by electron microscopy. The drawback of this method is that the PCB is destroyed for the measuring process, the analysis is expensive, time consuming, and sophisticated. In another technique, the OSP is chemically dissolved and a concentration of the dissolved compounds forming the OSP is determined. From the concentration of said compounds an average thickness of OSP in the contact pad is calculated. A clear drawback of this method is, besides that at least the OSP is destroyed, that only an average and theoretical thickness is determined. Although it is a quick method, the individual thickness of a particular OSP in a specific opening cannot be determined. Furthermore, these techniques are only suitable for random sampling. In addition, it is impossible to implement such methods for an active real-time inspection.

In other approaches, non-destructive methods are applied. For example, US 2006/023936 A1 refers to a film detection apparatus for detecting an organic film formed on a printed circuit board, an inspection system, and a method of inspecting a printed circuit board.

US 2012/092488 A1 refers to a precision solder resist registration inspection method, including a method for operating a machine vision inspection system to determine a fluorescent imaging height for acquiring a fluorescent image for repeatably determining the location of a workpiece feature edge that is located within a layer of fluorescent material on a workpiece.

### OBJECT OF THE INVENTION

The object of the invention was to provide an improved and significantly simplified method for obtaining information about a layer of an organic solderability preservative on a printed circuit board, in particular for determining an individual thickness of a layer of an organic solderability preservative on a printed circuit board, thereby avoiding the drawbacks mentioned above. It was particularly desired to utilize such a simplified method as an active manufacturing control. Particularly it was also an object to provide an improved method for obtaining a thickness profile of an OSP layer.

### SUMMARY OF THE INVENTION

The invention provides a method for obtaining information about a layer of an organic solderability preservative on a printed circuit board according to claim 1. Specific embodiments are object of dependent claims or described in this patent specification.

Thus, the invention provides a method for obtaining information about a layer of an organic solderability preservative on a printed circuit board, the method comprising
- Providing or producing a printed circuit board having a copper layer covering a part of an area of the printed circuit board,
   wherein a solder resist is placed on the copper layer, and the solder resist has openings wherein in the openings a copper surface of the copper layer is covered by a layer of an organic solderability preservative with an individual thickness,
- Providing a fluorescence measuring system, comprising
   a radiation source suitable for emitting a radiation beam,
   a detection unit for detecting fluorescent radiation, and
   a movement device which is arranged to move the radiation source and the printed circuit board relatively to each other in at least one dimension,
   the method comprising following steps
   a) Obtaining information about the location of the openings on the printed circuit board,
   b) Selecting at least one of the openings, thereby obtaining at least one selected opening,
   c) Moving the radiation source and the printed circuit board relatively to each other with the movement device and placing the radiation source at such position that the radiation beam irradiates into the at least one selected opening, and on the layer of the organic solderability preservative in the at least one selected opening,
   d) Detecting the fluorescent radiation which is emitted from the organic solderability preservative with the detection unit.

The detected fluorescent radiation is preferably used as information in quality control and information in further production and processing of OSP layers on PCBs. Further explanations are given below. When detecting the fluorescent radiation, preferably a signal, particularly an intensity of the signal is detected.

In a specific embodiment, the method is a method for determining an individual thickness of the layer of the organic solderability preservative, the method further comprising step:
e) Determining the individual thickness of the layer of the organic solderability preservative in the at least one selected opening.

By this method, an individual thickness of a layer of an OSP is determined with the help of fluorescent radiation, preferably in each selected opening.

The term "individual thickness" means a thickness in a selected opining. The term individual expresses that in different openings different thicknesses of an OSP layer may occur, so that the thickness is an individual thickness.

The method of the present invention is performed without damaging or destroying the printed circuit board.

In the method, the measuring system, particularly the radiation source, preferably is moved at any surface location of the PCB and the individual thickness of the OSP is preferably determined at any desired location having an opening in the solder resist.

The method allows determining an individual thickness of a layer of OSP on a PCB with preferably high resolution, thereby avoiding erroneous readings caused by fully or partly irradiating the solder resist. Solder resist compounds typically emit fluorescence radiation upon excitation. Thus, if a solder resist is (also) irradiated instead of OSP or together with OSP, wrong results would be obtained. This can be avoided by the method of the present invention.

The method of the present invention is a nondestructive method for determining the layer thickness and preferably in addition a thickness distribution of OSP on a PCB. The method allows a significantly increased process reliability, and helps to save chemicals and resources.

By a higher reliability of the method, thickness of OSP may be adjusted more precisely without necessity of creating a thicker OSP as necessary, in order to guarantee a minimum thickness.

The method of the present invention is quick, cheap, and significantly simple, preferably compared to methods used in the art, the method furthermore allowing large scale production control.

### DETAILED DESCRIPTION OF THE INVENTION

In the fluorescence measuring system, the radiation source emitting a radiation beam, preferably emits radiation in the UV range. The radiation source is preferably a laser. Preferably, the radiation source optimally has a power of up to 150 mW. Preferred is a method of the present invention, wherein the radiation beam has a power in a range from 20 mW to 200 mW, preferably in a range from 40 mW to 180 mW, more preferably in a range from 60 mW to 160 mW, most preferably in a range from 80 mW to 140 mW.

The radiation beam preferably irradiates an area of 0.5 - 1 mm² on the layer of the organic solderability preservative.

The opening has preferably an area of at least 1 mm², most preferably the at least one selected opening has an area of at least 1 mm². An upper limit of the area is preferably 100 mm².

The radiation beam causes fluorescent radiation in the selected/radiated opening and the fluorescent radiation is emitted from the OSP and detected by the detection unit.

The detection unit is preferably a photodiode.

By the movement device the radiation source and the PCB are moved relatively to each other, so that in such relative movement the radiation source is moved along the surface, or adjacent to the surface of the PCB, without contacting the PCB.

One of the radiation source and the PCB are preferably held in stationary position and the other is moved by the movement device. In another embodiment, both the radiation source and the PCB are moved by the movement device.

Preferably, the radiation source is coupled to the movement device.

The method preferably further comprises: Placing the printed circuit board adjacent to the movement device. This embodiment is preferably applied when the printed circuit board is resting in stationary position and the fluorescence measuring system is moved by the movement device.

Preferably, the movement device is arranged to move
- the radiation source and the detection unit, and
- the printed circuit board
relatively to each other in at least two dimensions.

The movement in two dimensions is preferably in such a way that in the movement a distance between the radiation source and the PCB, particularly the surface of the PCB, is held constant or essentially constant.

In a chosen cartesian coordinate system, the PCB, particularly the copper layer and the layer of OSP, preferably extends in X and Y direction (wherein the PCB and the layers of course have a thickness in Z-direction) and the relative movement is preferably done in one or more of the X and the Y direction.

Preferably, the movement is also possible in a third dimension. In a cartesian coordinate system, the PCB preferably extends in X and Y direction and the relative movement is preferably done in one or more of the X direction, the Y direction and the Z direction. Movement in Z direction allows adapting the method to different thicknesses of the PCB, either at the location where thickness of OSP is determined or during relative movement.

The movement device preferably comprises a holding device for holding the radiation source, and preferably also the detection unit.

The movement device preferably comprises linear guidings allowing the movement of one or more of
- the radiation source, and preferably also the detection unit,
- the PCB.

The movement device preferably comprises a motor and/or a gearing mechanism for effecting movement.

The movement device preferably allows moving in steps of 0.1 - 0.5 mm in one direction.

In each case, the openings have a location on the PCB, preferably with respect to at least two side edges of the PCB, wherein each opening has an individual information about its location. There are different possibilities for obtaining the information about the location of the openings on the printed circuit board. One possibility is visual inspection. For visual inspection a camera is preferably used.

A further possibility is that the information about the location of the openings is comprised in a data set. Then in step a) the information about the location of the openings is preferably obtained from the data set. On basis of this information, the selection in step b) is done.

The data set preferably comprises the information about the location in a Gerber format. This is an open ASCII vector format for 2D binary images.

Selecting at least one (i.e. one or more than one) of the openings in step b) is preferably done by individual decision or by a programmed procedure or workflow. For example when information about the location of the openings is obtained from mentioned data set, such information is preferably taken as basis for the selection in step b). Preferably, the selecting step b) then comprises selecting several openings in a predetermined order. Such order is preferably an order of size, or an order of location on the PCB.

Once the at least one of the openings is selected, the next step is preferably moving the radiation source and the printed circuit board relatively to each other with the movement device and placing the radiation source at such position that the radiation beam irradiates into the at least one selected opening, and on the layer of the organic solderability preservative in the at least one selected opening.

The method of the invention allows to specifically irradiating the layer of organic solderability preservative. Irradiating the solder resist, or additionally the solder resist, would lead to wrong determination of thickness. Thus the radiation source is preferably placed in such way that no solder resist is irradiated.

According to the method of the present invention, in step c) the radiation beam irradiates in such way that no solder resist is irradiated. With the method of the invention it is possible to determine a thickness also in very small openings because the measuring system allows a high resolution, for example when the radiation beam irradiates an area of 0.5 - 1 mm² only.

When detecting the fluorescent radiation which is emitted from the organic solderability preservative with the detection unit in step d), a signal, particularly an intensity of the fluorescent radiation is preferably detected.

When determining the thickness of the layer of OSP the intensity which is preferably detected in step d) is preferably allocated to the thickness of the layer of OSP. In other words, thickness of the layer is preferably determined from the intensity of the fluorescent radiation. In still other words, the intensity which is preferably detected in step d) is preferably set into relation to the thickness of the layer of OSP for determining the thickness of the layer of the OSP. Preferably, the intensity is dependent on the thickness of the layer. This dependency of intensity to thickness is preferably obtained by a calibration which is further described below.

Preferably, after each step d) the detected fluorescent radiation, preferably said intensity, form reading data, which are more preferably further processed into processed reading data. More preferably, in a subsequent step, the reading data and the processed reading data, respectively, are set into relation to reference reading data and processed reference reading data, respectively. Most preferably, in the method of the present invention, the reading data and the processed reading data, respectively, are set into relation to reference reading data and processed reference reading data, respectively, obtained from a reference sample with at least one reference layer of the organic solderability preservative having a known reference thickness. By this, the individual thickness of the layer of the organic solderability preservative is determined.

In order to conclude from a fluorescence radiation, particularly radiation intensity, to the thickness of OSP layer, a calibration is preferably performed. The method preferably comprises
- detecting a reference fluorescencent radiation of different reference samples of a reference layer of the organic solderability preservative, wherein in each of the reference samples the reference layer has a known thickness. For this step, the fluorescent measuring system is preferably used that is also used for determining the individual thickness of a layer of an organic solderability preservative
- obtaining an assignment of the reference fluorescent radiation to the thickness of the layer of the organic solderability preservative.

Said assignment is preferably be taken as a reference, in other words as a reference information.

The "known thickness" is preferably a thickness which is determined by another method. For example, the OSP layers of the reference samples are preferably be examined by microscopy, such as cutting or grinding through the layer and measuring the individual layer thickness with microscopy.

The assignment is preferably expressed as an assignment of values, for example expressed in a calibration data table, as a calibration curve, or be expressed in a mathematical relationship. In a simple embodiment, the assignment is a linear relationship.

In the method of the invention, a PCB is provided or produced. In the latter case producing of the printed circuit board preferably comprises depositing a layer of the organic solderability preservative in the openings and on a copper surface of the copper layer within the openings.

The individual thickness is preferably determined on basis of information of the assignment. This is preferably done by
- comparing a detected value of the fluorescent radiation from step d) with the assignment in order to find the same value in the assignment. The value in the assignment may be an interpolated value, in case that exactly the same value was not detected when establishing the assignment.
- identifying in the assignment the assigned thickness.

In one embodiment of the invention, the method comprises checking whether
- a signal or an intensity of the fluorescent radiation detected in step d), and/or
- the individual thickness of the layer of the organic solderability preservative determined in step e)
is within a desired range or a rated range.

This information is preferably used for quality control, as information for refinishing the PCB that was used in the method and/or as information to further influence a production process of further PCBs.

The signal or an intensity obtained when detecting the fluorescent radiation in step d) may be taken as an information about the thickness or the quality of the OSP layer without actually determining the thickness. For example, an intensity that is outside the desired range or rated range may indicate that the thickness of the OSP layer is too low or too high.

Preferably the method further comprises one or more of the following steps
i) discarding the printed circuit board
ii) refinishing the printed circuit board in order to change the individual thickness of the layer of the organic solderability preservative,
iii) adapting a method of production of a layer of the organic solderability preservative on at least one further printed circuit board in order to obtain an individual thickness of a layer of the organic solderability preservative on the at least one further printed circuit board in the desired range or the rated range.

A changed thickness results in a changed signal or changed intensity of the fluorescent radiation. When a PCB with changed thickness of OSP is checked or checked again, a changed signal or an intensity of the fluorescent radiation results and it can be determined whether this signal or intensity is in a desired or rated range, without determining the thickness (again).

In case of i) the PCB is discarded if the layer is thinner or thicker as desired.

In case ii) the method is also called a method for production of a layer the organic solderability preservative on the printed circuit board, this method comprising determining an individual thickness of the layer of the organic solderability preservative on the printed circuit board. The PCB is returned into the step of production of a layer the organic solderability preservative.

In case ii) the thickness of the OSP layer is preferably increased.

In case iii) the method is also called a method of production of a layer the organic solderability preservative on a printed circuit board, this method comprising determining an individual thickness of the layer of the organic solderability preservative on the printed circuit board.

In case iii) a production method is adapted in order to reach a desired thickness, as further described below. This is preferably done by adapting the deposition in the openings such that the layer of OSP in further PCB has an increased thickness or decreased thickness compared to the thickness before the adapting.

For example production of OSP is done by deposition. Deposition is preferably done by immersing into a solution OSP forming compounds. If the thickness is outside a desired of rated range, parameters of the method of depositing a layer of the organic solderability preservative are preferably changed.

Changing a method of production in iii) preferably comprises one or more of the following measures:
- interrupting the process of OSP production,
- changing concentration of OSP forming compounds in a solution comprising OSP forming compounds
- changing the process time, particularly the time of immersion in a solution comprising OSP forming compounds
- changing the process temperature
- changing pH of the solution comprising OSP forming compounds

In one embodiment the method of the invention comprises
- providing information about the location of the at least one selected opening on the printed circuit board to a controller which controls the movement of the radiation source and the printed circuit board relatively to each other,
wherein in step c) the moving of the radiation source and the printed circuit board relatively to each other and the placing of the radiation source is controlled by the controller. The controller is preferably a part of the movement device or part of a further device, for example a computer which is connected to the movement device.

Preferably, the method comprises determining individual thickness of the OSP at different locations within at least one selected opening. This allows obtaining a thickness profile of OSP within an opening.

The information for the controller is preferably provided from the data set mentioned above. The information is preferably provided in predetermined or programmed manner or predetermined or programmed order. This allows process automatization, particularly when thickness of OSP in more than one opening is determined or when within one opening thickness at different locations is determined, and/or when thickness at a plurality of PCB is determined. An order of openings on a PCB and/or desired locations of irradiation on a PCB are preferably defined and taken as information for controlling the process, particularly the relative movement of radiation source and PCB and the irradiation by the radiation beam of the radiation source.

In one embodiment of the method of the invention, steps b) to d) are repeated once or more, wherein in each repetition in step b) a further, which means: a different, opening is selected and the thickness of the layer of the organic solderability preservative is determined at the respective location of irradiation in the further opening. In this embodiment thickness in a plurality of openings is determined, preferably in predetermined order. A data set and a controller as mentioned above are preferably used. When steps b)-d) are repeated in the repetitions in step b) a sequence of different openings is preferably be taken as basis and the thickness of the layer of the organic solderability preservative is preferably determined at the respective location of irradiation in the different openings.

In a more specific embodiment, the further opening, or in case of more repetitions the further openings, has/have a different area, and the method further comprises:
- Determining an assignment between the area of an opening and the thickness of the layer of the organic solderability preservative.

In ideal case, thickness of OSP layer should not, or at least not strongly depend on the area of the opening, or the area of the OSP layer. Knowledge about such assignment provides information how the manufacturing process of the OSP could be influenced to reach this.

In a further embodiment of the method of the invention steps b) to d) are repeated once or more, wherein in each repetition in step b) the same opening is selected and in step c) the radiation source is moved to a different position so that within the same opening a different location on the layer of the organic solderability preservative is irradiated. In this embodiment thickness of OSP at a plurality of locations in an opening are preferably determined, preferably in predetermined order. A data set and a controller as mentioned above are preferably used. It is of course possible to combine this embodiment with the embodiment, wherein thickness of OSP is determined. It is of course possible to combine this embodiment with the previous embodiment, wherein thickness in different openings is determined.

The solder resist is not limited in any way. The solder resist preferably comprises an epoxy resin.

The organic solderability preservative whose thickness is determined in the openings is a solid substance, particularly a solid layer. Preferred is a method of the present invention, wherein the layer of the organic solderability preservative in the openings is a polymerized and cured layer.

In one embodiment of the method, the organic solderability preservative (OSP) comprises an imidazole compound and/or a benzimidazole compound. The imidazole compound and/or benzimidazole compound is preferably the major constituent of the OSP, which means that it constitutes at least 50 wt.-% of the OSP. A further constituent of the OSP is Cu(I) which originates from the copper of whose surface the OSP is formed.

Cu(I) preferably forms a complex with the imidazole and/or the benzimidazole compound. The organic solderability preservative preferably comprises a imidazole-Cu(I) complex and/or a benzimidazole-Cu(I) complex. The layer of the organic solderability preservative is preferably at least in part an organometallic layer. The organometallic layer comprises copper as metal. The organometallic layer preferably shows a gradient of copper (I) concentration, the concentration preferably decreasing in direction to the outer surface of the layer.

So the OSP layer is preferably not only formed by the compounds that are deposited on copper when forming an OSP layer, such as (benz)imidazole, but also by copper from the copper layer itself, so that a complex layer is formed. With the method of the invention, individual thickness of such complex layer can be determined with high accuracy.

The imidazole compound is preferably an alkyl imidazole, particularly selected from the group consisting of ethyl imidazole, propyl imidazole, butyl imidazole, pentyl imidazole. The benzimidazole compound is preferably an alkyl benzimidazole, particularly selected from the group consisting of ethyl benzimidazole, propyl benzimidazole, butyl benzimidazole, pentyl benzimidazole.

The benzimidazole compound is preferably a halogen benzimidazole, particularly chloro benzimidazole. The benzimidazole compound is preferably a substituted or unsubstituted aryl benzimidazole, particularly selected from the group consisting of phenyl benzimidazole, diphenyl benzimidazole, chlorobenzyl benzimidazole, chlorophenyl benzimidazole, dichlorobenzyl-benzimidazole.

The organic solderability preservative preferably does not comprise epoxy resin.

The organic solderability preservative preferably comprises iodide.

Thickness of the OSP layer to be determined is preferably in the range of 50 to 500 nm, more preferably in a range from 100 nm to 470 nm, even more preferably in a range from 150 nm to 450 nm, still more preferably in a range from 200 nm to 430 nm, most preferably in a range from 250 nm to 410 nm.

In the method of the present invention, preferably in all the openings the copper surface of the copper layer are covered by a layer of the organic solderability preservative. This is most preferred because instead of conventionally covering such openings with tin, a tin alloy, nickel, gold, or combinations thereof, preferably said organic solderability preservative is used in order to temporarily prevent oxidation of the copper surface. Therefore, preferred is a method of the present invention, wherein before forming OSP layers in openings the printed circuit board does not comprise an opening covered with tin, a tin alloy, nickel, gold, or combinations thereof.

Preferred is a method of the present invention, wherein the radiation beam has a wave length in a range from 250 nm to 450 nm, preferably in a range from 300 nm to 400 nm, most preferably in a range from 350 nm to 375 nm.

Preferred is a method of the present invention, wherein the fluorescent radiation has a wave length in a range from 350 nm to 550 nm, preferably in a range from 400 nm to 520 nm, most preferably in a range from 450 nm to 470 nm.

Preferably, the wave length of the radiation beam is not identical with the wave length of the fluorescent radiation. More preferred is a method of the present invention, wherein the wave length of the radiation beam is lower than the wave length of the fluorescent radiation. Most preferred is a method of the present invention, wherein the wave length of the radiation beam is in a range from 350 nm to 375 nm and the wave length of the fluorescent radiation is in a range from 450 nm to 470 nm.

As mentioned before, the method of the present invention is a non-destructive method. Thus, preferred is a method of the present invention, wherein in step c) none of the layer of the organic solderability preservative is removed, i.e. neither partly nor entirely.

Preferred is a method of the present invention, wherein the radiation beam is not an X-ray radiation beam.

Preferred is a method of the present invention, wherein more than one individual thickness is determined and which are provided as an individual thickness distribution.

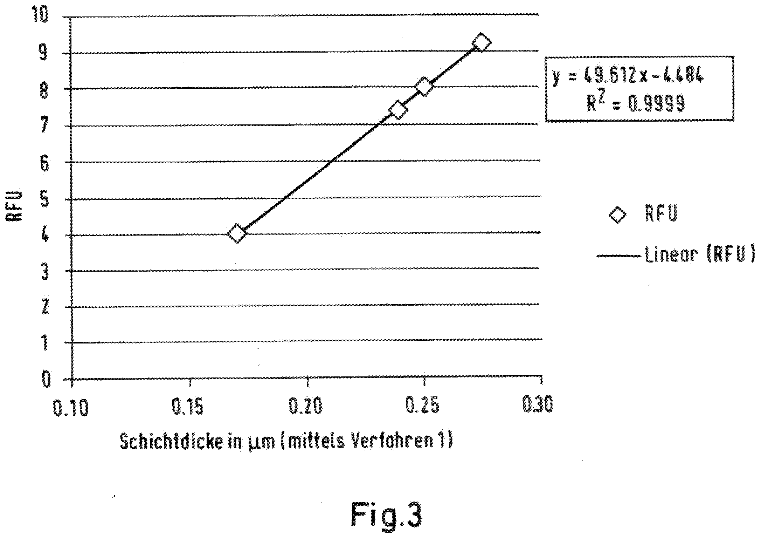

Preferred is a method of the present invention, wherein the fluorescent radiation detected in step d) and the individual thickness of the layer of the organic solderability preservative correlate linearly. This is confirmed in Fig. 3.

Preferred is a method of the present invention, wherein at least a number of the openings is filled with a pre-solder and preferably subjected to a heat treatment to obtain pre-soldered openings, wherein during the heat treatment the organic solderability preservative is decomposed. Preferably the pre-solder comprises tin and/or nickel.

### BRIEF DESCRIPTION OF THE FIGURES

Fig. 1 shows schematically the arrangement of the printed circuit board and the fluorescence measuring system utilized in the method of the present invention;
Fig. 2 shows the fluorescence measuring system, a printed circuit board, and the movement device in one particular embodiment of the method of the present invention;
Fig. 3 shows a calibration line of SITA cleano spector versus layer thickness of OSP;
Fig. 4 shows a top view of a PCB and a number of measuring points thereon;
Fig. 5 shows an overview of the steps of the method of the invention.

### EXAMPLES

The fluorescence measuring system was the CleanoSpector^{®}, by SITA Company, a laser based Fluorescence measuring head.

### Measuring principle:

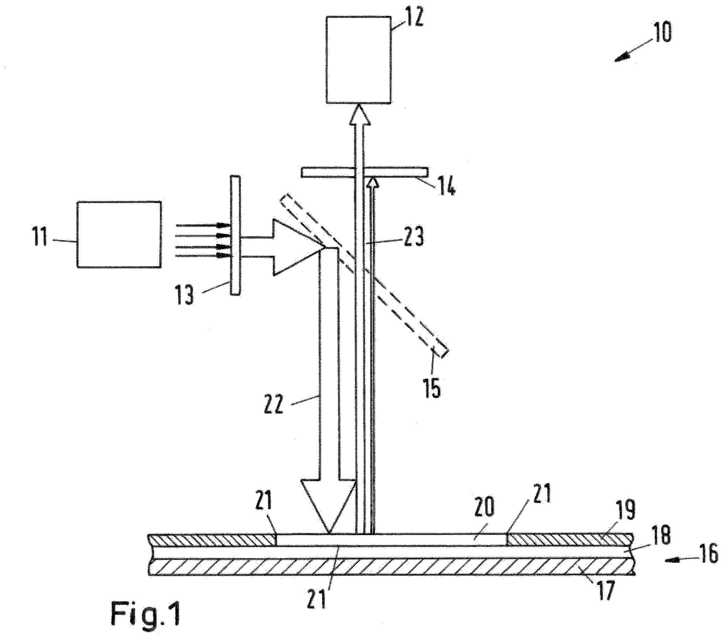

The principle is shown in Fig. 1. The SITA CleanoSpector uses an excitation frequency of 365 nm and detects the emitted light from a respective substrate with a frequency of 460 nm. A beam guidance and various filters ensure that only the emitted light reaches the detector. It can record values between 0-2000 RFU (Relative Fluorescence Units).

With increasing layer thickness of the OSP, an increased RFU is recorded or output. The layer thickness of the OSP can be determined by means of standards and calibration lines.

In Fig. 1 following components are shown:
- 10: fluorescence measuring system
- 11: radiation source, emitting a radiation beam
- 12: detection unit, which preferably is an optical detection unit
- 13: low pass filter
- 14: high pass filter
- 15: semi permeable mirror
- 16: printed circuit board (PCB)
- 17: substrate for the copper layer, part of the PCB
- 18: copper layer, part of the PCB
- 19: solder resist, part of the PCB
- 20: organic solderability preservative (OSP)
- 21: openings (edge of opening in this cross sectional view) allowing access to a contact pad
- 22: radiation beam, UV light
- 23: fluorescent radiation

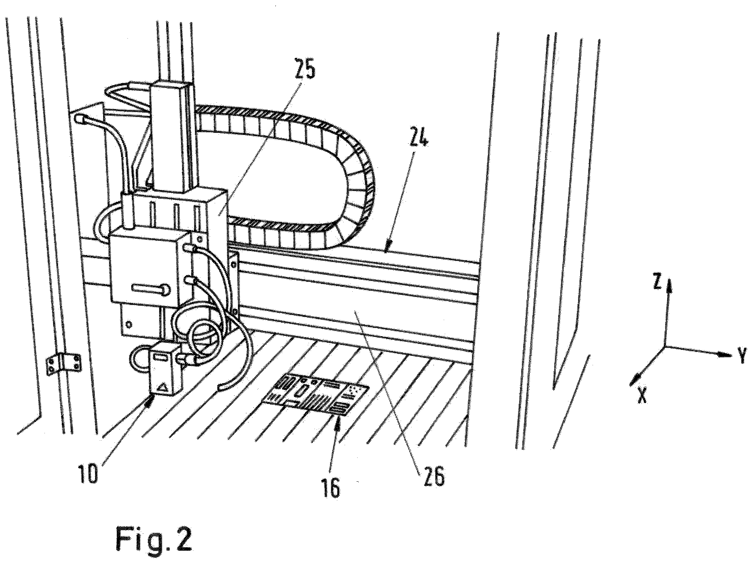

Fig. 2 shows the measuring system 10 and in addition the movement device 24. The movement device 24 comprises the holding device 25 to which the measuring system 10 is attached by fixing means. The holding device is movable along the guidance 26 in a direction Y and along another guidance (not shown) in a direction X, perpendicular to Y (coordinate system is shown). Movement is effected by a motor and gearing mechanism (not shown). The printed circuit board 16 is oriented in X-Y direction, so that the fluorescence measuring system 10 may be moved, by the movement device 24, at any place across and above the printed circuit board 16.

### Example 1 (Calibration)

Four samples of FR4 base materials (5x5 cm) each with a 35 µm copper foil are deposited with a layer of organic solderability preservative Atotech OS Tech^{®} with different OSP layer thicknesses as a result of different deposition times within a range from 15 seconds to 120 seconds. The main constituent of this OSP is 2 - [(4-chlorophenyl) methyl] -1H-benzimidazole. Table 1 shows the results.

Method 1 (not according to the present invention): Peeling off the entire OSP with 0.5% HCl and determining the concentration based on a UV measuring at 270 nm in a defined volume. As a result, an average layer thickness is calculated. This was used for establishing a calibration curve (Fig. 3)

Method 2 (not according to the present invention): Making a cross-section and determining the layer thickness by means of a scanning electron microscope (FIB).

Method 3 (according to the present invention): SITA Cleano Spector (Fig. 1); correlating the results of method 1 with method 3.

**Table 1: results**

| Sample No. | Thickness OSP, Method 1 | Thickness OSP, Method 3 | |
|---|---|---|---|
| | [µm] | RFU | [µm]* |
| 1 | 0.17 | 4.0 | 0.17 |
| 2 | 0.24 | 7.4 | 0.23 |
| 3 | 0.25 | 8.0 | 0.26 |
| 4 | 0.28 | 9.2 | 0.29 |

Fig. 3 is a calibration line, setting the measured RFU into relation to the thickness measures according to method 1. * denotes additional results obtained by method 2.

Example 1 shows a very reliable correlation.

### Example 2

The layer thickness distribution is determined on a printed circuit board by means of two methods. For this purpose, measurements are taken on different and similar openings, covered with OSP, on the printed circuit board.

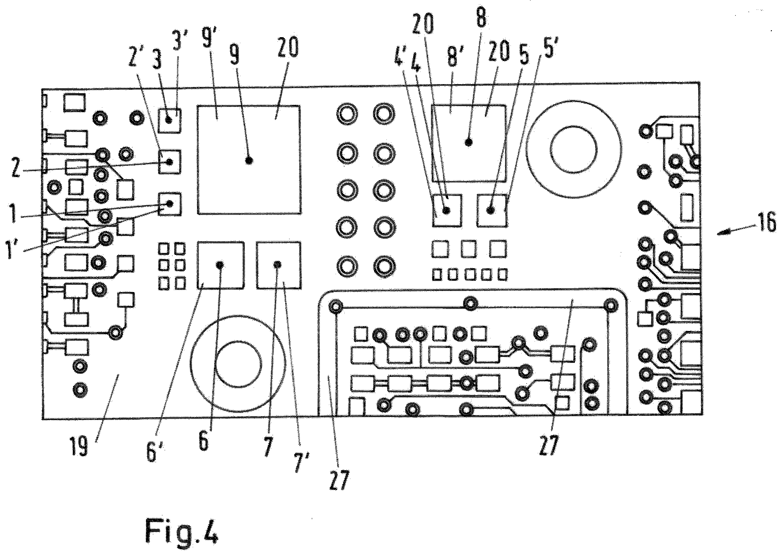

Fig. 4 shows a top view of a PCB and the measuring points 1-9. Each of the measuring points is located in a different opening wherein no solder resist 19 is deposited, the openings designated as 1' - 9'. Some of the openings differ in area 1' - 9'. Parts of copper are covered by solder resist 19, such as a conductive path 27 which is covered.

**Table 2: results**

| Measuring point | Area of opening | Thickness OSP, Method 2 | Thickness OSP, Method 3 | |
|---|---|---|---|---|
| | mm2 | [µm] | RFU | [µm] |
| 1 | 1.56 | 0.34 | 24.7 | 0.34 |
| 2 | 1.56 | -- | 28.0 | 0.37 |
| 3 | 1.56 | -- | 32.5 | 0.42 |
| 4 | 4 | -- | 33.8 | 0.43 |
| 5 | 4 | 0.26 | 15.6 | 0.25 |
| 6 | 9 | 0.18 | 10.8 | 0.20 |
| 7 | 9 | -- | 12.3 | 0.21 |
| 8 | 25 | 0.14 | 7.9 | 0.17 |
| 9 | 49 | 0.19 | 10.2 | 0.19 |

Thickness according to method 3 was obtained with the calibration used in example 1 (Fig. 3).

It can be seen that thickness of the OSP layer in an opening and on a contact pad is dependent from the size of the opening. For example, thickness in the larger openings 8' and 9' (measuring points 8 and 9) is lower than in the smaller openings1' - 3' (measuring points 1-3). Therefore, it is a great advantage of the method of the present invention that the individual thickness is reliably determined.

It can be seen that in the opening with the largest area, measuring point 9, the layer thickness is increased in comparison to the smaller opening with measuring point 8. This is an unexpected result but shows the advantage of the method of the invention which allows determining the individual thickness in an individual openings and allows determining such unexpected results, which can be used as a basis for adaptation of the production process of OSP layers on PCBs.

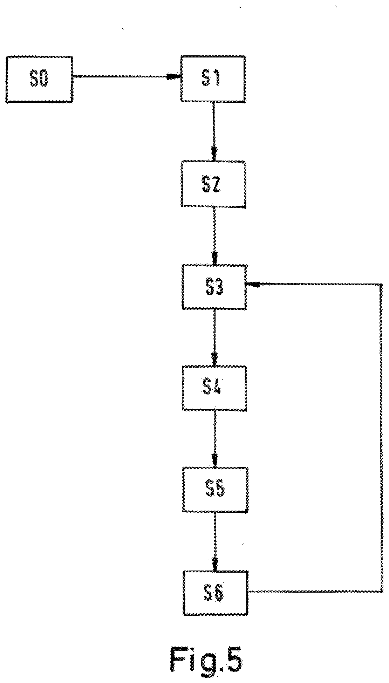

Fig. 5 shows an overview of the whole method of the invention, in a basic embodiment. It is referred to previous Figures, particularly Figs. 1 and 2, and the previous examples.

S1: Placing the printed circuit board 16 adjacent to the movement device 24 of the fluorescence measuring system 10. This is shown in Fig. 2

S2: Obtaining information about the location of the openings on the printed circuit board 16. Here, data from a data set (Gerber data set) is preferably provided to a controller (not shown) which e.g. controls the movement of the movement device 24. Data are preferably selected by a program. As an alternative, information can be obtained by visual inspection of the PCB 16 with a camera.

S3: Selecting at least one of the openings 21. This selection is preferably done by individual decision or by a computer program.

S4: Moving preferably the radiation source 11 with the movement device 24 and placing the radiation source at such position that the radiation beam 22 irradiates into the at least one selected opening 21, and on the layer of organic solderability preservative 20 in the at least one selected opening, as shown in Figs. 1 and 2.

S5: Detecting a fluorescence radiation 23 which is emitted from the organic solderability preservative 20 with the detection unit 12, as shown in Fig. 1.

S6: Determining the individual thickness of the layer of the organic solderability preservative 20 at the location of irradiation in the at least one selected opening 21. This was explained in above examples 1 and 2.

Steps S3-S6 are preferably repeated, for example in different openings and/or at different measuring points, e.g. 1-9, as shown in Fig. 4.

## Claims

1. A method for obtaining information about a layer of an organic solderability preservative on a printed circuit board, the method comprising
- Providing or producing a printed circuit board (16) having a copper layer (18) covering a part of an area of the printed circuit board (16),
wherein a solder resist (19) is placed on the copper layer (18), and the solder resist (19) has openings (21) wherein in the openings (21) a copper surface of the copper layer (18) is covered by a layer of an organic solderability preservative with an individual thickness (20),
- Providing a fluorescence measuring system (10), comprising
a radiation source (11) suitable for emitting a radiation beam (22),
a detection unit (12) for detecting fluorescent radiation (23), and
a movement device (24) which is arranged to move the radiation source (11) and the printed circuit board (16) relatively to each other in at least one dimension,
the method comprising following steps
a) Obtaining (S2) information about the location of the openings (21) on the printed circuit board (16),
b) Selecting (S3) at least one of the openings (21), thereby obtaining at least one selected opening,
c) Moving (S4) the radiation source (11) and the printed circuit board (16) relatively to each other with the movement device (24) and placing the radiation source (11) at such position that the radiation beam (22) irradiates into the at least one selected opening (21), and on the layer of the organic solderability preservative (20) in the at least one selected opening,
d) Detecting (S5) the fluorescent radiation (23) which is emitted from the organic solderability preservative (20) with the detection unit (12).
wherein in step c) the radiation beam (22) irradiates in such way that no solder resist (19) is irradiated.

2. The method of claim 1, wherein the method is a method for determining an individual thickness of the layer of the organic solderability preservative, the method further comprising step
e) Determining (S6) the individual thickness of the layer of the organic solderability preservative (20) in the at least one selected opening.

3. The method of one of the preceding claims, comprising
- detecting a reference fluorescence radiation of different reference samples of a reference layer of the organic solderability preservative, wherein in each of the reference samples the reference layer has a known thickness,
- obtaining an assignment of the reference fluorescent radiation to the thickness of the layer of the organic solderability preservative.

4. The method of claim 2 and 3, wherein the individual thickness is determined on basis of the assignment.

5. The method of one of the claims 1-4, comprising checking whether
- a signal or an intensity of the fluorescent radiation detected in step d), and/or
- the individual thickness of the layer of the organic solderability preservative determined in step e)
is within a desired range or a rated range.

6. The method of claim 5, further comprising one or more of the following steps
i) discarding the printed circuit board (16)
ii) refinishing the printed circuit board (16) in order to change the individual thickness of the layer of the organic solderability preservative,
iii) adapting a method of production of a layer of the organic solderability preservative on at least one further printed circuit board in order to obtain an individual thickness of a layer of the organic solderability preservative on the at least one further printed circuit board in the desired range or the rated range.

7. The method of one of the preceding claims, wherein the information about the location of the openings is comprised in a data set, and in step a) the information about the location of the openings is obtained from the data set.

8. The method of one of the preceding claims, comprising
- providing information about the location of the at least one selected opening on the printed circuit board to a controller which controls the movement of the radiation source (11) and the printed circuit board (16) relatively to each other,
wherein in step c) the moving of the radiation source (11) and the printed circuit board (16) relatively to each other and the placing of the radiation source is controlled by the controller.

9. The method of one of claims 2-8, wherein steps b) to d) are repeated once or more,
wherein in each repetition in step b) a further opening is selected and wherein the thickness of the layer of the organic solderability preservative is determined at the respective location of irradiation in the further opening.

10. The method of claim 9, wherein the further opening, or in case of more repetitions the further openings, has/have a different area, the method further comprising
- Determining an assignment between the area of an opening and the thickness of the layer of the organic solderability preservative.

11. The method of one of the preceding claims, wherein steps b) to d) are repeated once or more, wherein in each repetition in step b) the same opening is selected and in step c) the radiation source is moved to a different position so that within the same opening a different location on the layer of the organic solderability preservative is irradiated.

12. The method of one of the preceding claims, wherein the organic solderability preservative comprises an imidazole compound and/or a benzimidazole compound.

13. The method of one of the preceding claims, wherein the organic solderability preservative comprises a imidazole-Cu(I) complex and/or a benzimidazole-Cu(I) complex wherein the layer of the organic solderability preservative is at least in part an organometallic layer.

14. The method of one of the preceding claims, wherein the radiation beam irradiates an area of 0.5 - 1 mm² on the layer of the organic solderability preservative.

15. The method of one of the preceding claims, wherein manufacturing of the printed circuit board (16) comprises depositing (S0) a layer of the organic solderability preservative (20) in the openings (21) and on a copper surface of the copper layer (18) within the openings (21).

16. The method of one of the preceding claims, wherein the at least one selected opening (21) has an area of at least 1 mm².

## Patentansprüche

1. Verfahren zum Erhalten von Informationen über eine Schicht eines organischen Lötbarkeitsschutzmittels auf einer Leiterplatte, das Verfahren umfassend
- Bereitstellen oder Herstellen einer Leiterplatte (16), die eine Kupferschicht (18) aufweist, die einen Teil einer Fläche der Leiterplatte (16) bedeckt, wobei ein Lötstopplack (19) auf der Kupferschicht (18) platziert ist, und der Lötstopplack (19) Öffnungen (21) aufweist, wobei in den Öffnungen (21) eine Kupferoberfläche der Kupferschicht (18) durch eine Schicht eines organischen Lötbarkeitsschutzmittels mit einer einzelnen Dicke (20) bedeckt ist,
- Bereitstellen eines Fluoreszenzmesssystems (10), umfassend eine Strahlungsquelle (11), die zum Emittieren eines Strahlungsstrahls (22) geeignet ist, eine Erfassungseinheit (12) zum Erfassen von Fluoreszenzstrahlung (23) und eine Bewegungsvorrichtung (24), die angeordnet ist, um die Strahlungsquelle (11) und die Leiterplatte (16) in mindestens einer Dimension relativ zueinander zu bewegen,
das Verfahren umfassend folgende Schritte
a) Erhalten (S2) von Informationen über den Standort der Öffnungen (21) auf der Leiterplatte (16),
b) Auswählen (S3) mindestens einer der Öffnungen (21), wodurch mindestens eine ausgewählte Öffnung erhalten wird,
c) Bewegen (S4) der Strahlungsquelle (11) und der Leiterplatte (16) relativ zueinander mit der Bewegungsvorrichtung (24) und Platzieren der Strahlungsquelle (11) an einer solchen Position, dass der Strahlungsstrahl (22) in die mindestens eine ausgewählte Öffnung (21) strahlt, und auf der Schicht des organischen Lötbarkeitsschutzmittels (20) in der mindestens einen ausgewählten Öffnung,
d) Erfassen (S5) der fluoreszierenden Strahlung (23), die von dem organischen Lötbarkeitsschutzmittel (20) emittiert wird, mit der Erfassungseinheit (12) wobei in Schritt c) der Strahlungsstrahl (22) derart strahlt, dass kein Lötstopplack (19) bestrahlt wird.

2. Verfahren nach Anspruch 1, wobei das Verfahren ein Verfahren zum Bestimmen einer einzelnen Dicke der Schicht des organischen Lötbarkeitsschutzmittels ist, das Verfahren ferner umfassend den Schritt
e) Bestimmen (S6) der einzelnen Dicke der Schicht des organischen Lötbarkeitsschutzmittels (20) in der mindestens einen ausgewählten Öffnung.

3. Verfahren nach einem der vorstehenden Ansprüche, umfassend
- Erfassen einer Referenzfluoreszenzstrahlung unterschiedlicher Referenzproben einer Referenzschicht des organischen Lötbarkeitsschutzmittels, wobei in jeder der Referenzproben die Referenzschicht eine bekannte Dicke aufweist,
- Erhalten einer Zuweisung der Referenzfluoreszenzstrahlung auf die Dicke der Schicht des organischen Lötbarkeitsschutzmittels.

4. Verfahren nach Anspruch 2 und 3, wobei die einzelne Dicke basierend auf der Zuweisung bestimmt wird.

5. Verfahren nach einem der Ansprüche 1 bis 4, umfassend ein Prüfen, ob
- ein Signal oder eine Intensität der Fluoreszenzstrahlung, die in Schritt d) erfasst wird, und/oder
- die einzelne Dicke der Schicht des organischen Lötbarkeitsschutzmittels, die in Schritt e) bestimmt wird,
innerhalb eines gewünschten Bereichs oder eines Nennbereichs liegt.

6. Verfahren nach Anspruch 5, ferner umfassend einen oder mehrere der folgenden Schritte
i) Verwerfen der Leiterplatte (16)
ii) Nachbearbeiten der Leiterplatte (16), um die einzelne Dicke der Schicht des organischen Lötbarkeitsschutzmittels zu ändern,
iii) Anpassen eines Verfahrens für eine Herstellung einer Schicht des organischen Lötbarkeitsschutzmittels auf mindestens einer weiteren Leiterplatte, um eine einzelne Dicke einer Schicht des organischen Lötbarkeitsschutzmittels auf der mindestens einen weiteren Leiterplatte in dem gewünschten Bereich oder dem Nennbereich zu erhalten.

7. Verfahren nach einem der vorstehenden Ansprüche, wobei die Informationen über den Standort der Öffnungen in einem Datensatz enthalten sind, und in Schritt a) die Informationen über den Standort der Öffnungen aus dem Datensatz erhalten werden.

8. Verfahren nach einem der vorstehenden Ansprüche, umfassend
- Bereitstellen von Informationen über den Standort der mindestens einen ausgewählten Öffnung auf der Leiterplatte an eine Steuerung, die die Bewegung der Strahlungsquelle (11) und der Leiterplatte (16) relativ zueinander steuert,
wobei in Schritt c) das Bewegen der Strahlungsquelle (11) und der Leiterplatte (16) relativ zueinander und das Platzieren der Strahlungsquelle durch die Steuerung gesteuert wird.

9. Verfahren nach einem der Ansprüche 2 bis 8, wobei die Schritte b) bis d) einmal oder mehr wiederholt werden, wobei in jeder Wiederholung in Schritt b) eine weitere Öffnung ausgewählt wird, und wobei die Dicke der Schicht des organischen Lötbarkeitsschutzmittels an dem jeweiligen Bestrahlungsstandort in der weiteren Öffnung bestimmt wird.

10. Verfahren nach Anspruch 9, wobei die weitere Öffnung, oder im Falle von mehr Wiederholungen die weiteren Öffnungen, eine unterschiedliche Fläche aufweist/aufweisen, das Verfahren ferner umfassend
- Bestimmen einer Zuweisung zwischen der Fläche einer Öffnung und der Dicke der Schicht des organischen Lötbarkeitsschutzmittels.

11. Verfahren nach einem der vorstehenden Ansprüche, wobei die Schritte b) bis d) einmal oder mehr wiederholt werden, wobei in jeder Wiederholung in Schritt b) die gleiche Öffnung ausgewählt wird und in Schritt c) die Strahlungsquelle in eine unterschiedliche Position bewegt wird, so dass innerhalb derselben Öffnung ein unterschiedlicher Standort auf der Schicht des organischen Lötbarkeitsschutzmittels bestrahlt wird.

12. Verfahren nach einem der vorstehenden Ansprüche, wobei das organische Lötbarkeitsschutzmittel eine Imidazolverbindung und/oder eine Benzimidazolverbindung umfasst.

13. Verfahren nach einem der vorstehenden Ansprüche, wobei das organische Lötbarkeitsschutzmittel ein Imidazol-Cu(I)-Komplex und/oder ein Benzimidazol-Cu(I)-Komplex umfasst, wobei die Schicht des organischen Lötbarkeitsschutzmittels mindestens teilweise eine organometallische Schicht ist.

14. Verfahren nach einem der vorstehenden Ansprüche, wobei der Strahlungsstrahl eine Fläche von 0,5 bis 1 mm² auf die Schicht des organischen Lötbarkeitsschutzmittels bestrahlt.

15. Verfahren nach einem der vorstehenden Ansprüche, wobei ein Fertigen der Leiterplatte (16) ein Abscheiden (S0) einer Schicht des organischen Lötbarkeitsschutzmittels (20) in den Öffnungen (21) und auf einer Kupferoberfläche der Kupferschicht (18) innerhalb der Öffnungen (21) umfasst.

16. Verfahren nach einem der vorstehenden Ansprüche, wobei die mindestens eine ausgewählte Öffnung (21) eine Fläche von mindestens 1 mm² aufweist.

## Revendications

1. Procédé destiné à obtenir des informations concernant une couche d'un conservateur de soudabilité organique sur une carte de circuit imprimé, le procédé comprenant
- la fourniture ou la production d'une carte de circuit imprimé (16) ayant une couche de cuivre (18) couvrant une partie d'une zone de la carte de circuit imprimé (16), une réserve de soudure (19) étant placée sur la couche de cuivre (18), et la réserve de soudure (19) ayant des ouvertures (21), dans les ouvertures (21), une surface de cuivre de la couche de cuivre (18) étant recouverte par une couche d'un conservateur organique de soudabilité avec une épaisseur individuelle (20),
- la fourniture d'un système de mesure de fluorescence (10), comprenant une source de rayonnement (11) adaptée pour émettre un faisceau de rayonnement (22), une unité de détection (12) pour détecter un rayonnement fluorescent (23), et un dispositif de déplacement (24) qui est agencé pour déplacer la source de rayonnement (11) et la carte de circuit imprimé (16) l'une par rapport à l'autre dans au moins une dimension,
le procédé comprenant les étapes suivantes
a) L'obtention (S2) d'informations concernant l'emplacement des ouvertures (21) sur la carte de circuit imprimé (16),
b) La élection (S3) d'au moins une des ouvertures (21), obtenant ainsi au moins une ouverture sélectionnée,
c) Le déplacement (S4) de la source de rayonnement (11) et la carte de circuit imprimé (16) l'une par rapport à l'autre avec le dispositif de déplacement (24) et le déplacement de la source de rayonnement (11) à une position telle que le faisceau de rayonnement (22) irradie dans l'au moins une ouverture sélectionnée (21), et sur la couche du conservateur organique de soudabilité (20) dans l'au moins une ouverture sélectionnée,
d) La détection (S5) du rayonnement fluorescent (23) qui est émis par le conservateur organique de soudabilité (20) avec l'unité de détection (12).
à l'étape c) le faisceau de rayonnement (22) irradie de telle sorte qu'aucune réserve de soudure (19) n'étant irradiée.

2. Procédé selon la revendication 1, dans lequel le procédé est un procédé pour déterminer une épaisseur individuelle de la couche du conservateur organique de soudabilité, le procédé comprenant en outre l'étape suivante
e) La détermination (S6) de l'épaisseur individuelle de la couche du conservateur organique de soudabilité (20) dans l'au moins une ouverture sélectionnée.

3. Procédé selon l'une des revendications précédentes, comprenant
- la détection d'un rayonnement de fluorescence de référence de différents échantillons de référence d'une couche de référence du conservateur organique de soudabilité, dans chacun des échantillons de référence, la couche de référence ayant une épaisseur connue,
- l'obtention d'une attribution du rayonnement fluorescent de référence à l'épaisseur de la couche du conservateur organique de soudabilité.

4. Procédé selon la revendication 2 et 3, dans lequel l'épaisseur individuelle est déterminée sur la base de l'attribution.

5. Procédé selon l'une des revendications 1 à 4, comprenant le fait de vérifier si
- un signal ou une intensité du rayonnement fluorescent détecté à l'étape d), et/ou
- l'épaisseur individuelle de la couche du conservateur organique de soudabilité déterminée à l'étape e)
est dans une plage souhaitée ou une plage nominale.

6. Procédé selon la revendication 5, comprenant en outre une ou plusieurs des étapes suivantes
i) le rejet de la carte de circuit imprimé (16)
ii) le raffinement de la carte de circuit imprimé (16) afin de modifier l'épaisseur individuelle de la couche du conservateur organique de soudabilité,
iii) l'adaptation d'un procédé de production d'une couche du conservateur de soudabilité organique sur au moins une carte de circuit imprimé supplémentaire afin d'obtenir une épaisseur individuelle d'une couche du conservateur de soudabilité organique sur l'au moins une autre carte de circuit imprimé dans la plage souhaitée ou la plage nominale.

7. Procédé selon l'une des revendications précédentes, dans lequel les informations concernant l'emplacement des ouvertures sont comprises dans un ensemble de données, et dans l'étape a) les informations concernant l'emplacement des ouvertures sont obtenues à partir de l'ensemble de données.

8. Procédé selon l'une des revendications précédentes, comprenant
- la fourniture des informations concernant l'emplacement de l'au moins une ouverture sélectionnée sur la carte de circuit imprimé à un dispositif de commande qui commande le mouvement de la source de rayonnement (11) et de la carte de circuit imprimé (16) l'une par rapport à l'autre,
à l'étape c) le déplacement de la source de rayonnement (11) et de la carte de circuit imprimé (16) l'un par rapport à l'autre et la mise en place de la source de rayonnement étant commandée par le dispositif de commande.

9. Procédé selon l'une des revendications 2 à 8, dans lequel les étapes b) à d) sont répétées une ou plusieurs fois, à chaque répétition de l'étape b), une ouverture supplémentaire étant sélectionnée et l'épaisseur de la couche du conservateur organique de soudabilité étant déterminée à l'emplacement respectif de l'irradiation dans l'ouverture supplémentaire.

10. Procédé selon la revendication 9, dans lequel l'ouverture supplémentaire, ou dans le cas de plus répétitions, les ouvertures supplémentaires, a/ont une zone différente, le procédé comprenant en outre
- La détermination d'une affectation entre la zone d'une ouverture et l'épaisseur de la couche du conservateur organique de soudabilité.

11. Procédé selon l'une des revendications précédentes, dans lequel les étapes b) à d) sont répétées une ou plusieurs fois, à chaque répétition de l'étape b), la même ouverture étant sélectionnée et à l'étape c) la source de rayonnement étant déplacée vers une position différente de sorte qu'au sein de la même ouverture un emplacement différent sur la couche du conservateur organique de soudabilité soit irradié.

12. Procédé selon l'une des revendications précédentes, dans lequel le conservateur organique de soudabilité comprend un composé imidazole et/ou un composé benzimidazole.

13. Procédé selon l'une des revendications précédentes, dans lequel le conservateur organique de soudabilité comprend un complexe imidazole-Cu(I) et/ou un complexe benzimidazole-Cu(I), la couche du conservateur organique de soudabilité étant au moins en partie une couche organométallique.

14. Procédé selon l'une des revendications précédentes, dans lequel le faisceau de rayonnement irradie une zone de 0,5 à 1 mm² sur la couche du conservateur organique de soudabilité.

15. Procédé selon l'une des revendications précédentes, dans lequel la fabrication de la carte de circuit imprimé (16) comprend le dépôt (S0) d'une couche du conservateur organique de soudabilité (20) dans les ouvertures (21) et sur une surface de cuivre de la couche de cuivre (18) à l'intérieur des ouvertures (21).

16. Procédé selon l'une des revendications précédentes, dans lequel l'au moins une ouverture sélectionnée (21) a une aire d'au moins 1 mm².
